# EUROPEAN PATENT APPLICATION

(11) **EP 2 246 983 A1**
(43) Date of publication of application: **03.11.2010**
(21) Application number: 09305358.5
(22) Date of filing: 27.04.2009
(51) Int. Cl.: H03K 19/00, H01L 23/50

(54) **Supply cell and integrated circuit comprising such supply cells.**

(71) Applicant: ST-Ericsson SA, 1228 Plan-les-Ouates (CH)
(72) Inventor: Mrcarica, Zeljko, 8049 ZURICH (CH); Notermans, Guido, 8049 ZÜRICH (CH); Maksimovic, Dejan, 8952 SCHLIEREN (CH)
(74) Representative: Zapalowicz, Francis

(57) **Abstract**

Supply cell, comprising input means (IM) configured to receive at least one input supply signal (Vdd), output means (OI1, OI2) configured to output at least one output supply signal (Vdd), control input means (CIM) configured to receive a control signal and switching means (SW) coupled to said control input means and between said input means and said output means and configured to be controlled by said control signal for switching on or off said output means (OI3, OI2).

## Description

The invention relates to integrated circuit design, especially low power integrated circuit design, and more particularly to the implementation of on-chip power switches.

In deep-submicron IC (integrated circuit) technology, the transistor leakage is posing a serious problem. It is especially important for mobile applications, where the battery life is determined to a high extent by the stand-by power, i.e. by the IC consumption when it is not active. One of the methods of reducing the leakage power is to switch off the power supply of the inactive part of the system. With a high level of integration, it is usually not possible to switch off the whole IC, since some parts of such complex circuits are always active. However, one or more blocks (subcircuits) of a system-on-chip (SoC) can be often switched off.

Therefore, different power domains can be distinguished in the circuit. For example, an always-on domain (AOD) is supplied also during the system stand-by time, and one or more switchable domains may be switched on or off by using power switches. The AOD is usually containing the control unit for the power switches. Power switches are usually transistors, typically PMOS, although NMOS can be also used.

The core of an integrated circuit is generally surrounded by a so-called input/output ring (IO ring), which comprises cells, which are usually treated as standard cells, usually contained in a specific library also named IO library.

The cells contained in the IO ring can be cells carrying input, output or input/output signals. Those cells are usually named IO cells and can be more particularly input cells, output cells, input/output cells. Other cells contained in the IO ring do not carry any signals, such as supply cells.

The power mesh of a switchable domain is separated from the power supply of the rest of the circuit (in particular the AOD and the supply cells of the IO ring) by the power switches. The switches themselves are controlled by a signal from the AOD domain. Therefore, one needs to create a specific path in the AOD domain all along the chip boundary, to be able to control the switches.

Besides, all the signals that are outputs of the switchable domain must be clamped using logic gates, in order to avoid propagation of undefined stats when the domain is switched off. Typically the number of such logic gates is very large due to large number of signals.

Further, several signals go directly to the output IO cells, and must be also clamped. Without that clamping, the IO cells would transfer the undefined logical value outside the chip, to other components in the system, therefore creating malfunction. The clamps themselves also have to be supplied by an AOD supply.

According to an embodiment, a power switch implementation is proposed, which simplifies implementation of the power switches in the circuit, simplifies the power mesh and reduces the number of signal clamps that are needed.

It is also proposed, according to an embodiment, to save die area as well as area needed for implementation of ESD (ElectroStatic Discharge) protections.

It is thus proposed, according to an embodiment, to provide a new supply cell for core power supply, containing the power switch. Thus, such a new supply cell may be also named thereafter a switchable supply cell. The power switch may also switch on and off the supply of the core side of the other input/output cells. In addition, the junctions of the power switch can be advantageously used as ESD protection.

According to an aspect, a supply cell is proposed comprising input means, for example a pad, configured to receive at least one input supply signal, for example a Vdd voltage, output means, for example pins towards the core of the switchable domain and a metallic strip, configured to output at least one output supply signal, control input means configured to receive a control signal, and switching means coupled to said control input means and between said input means and said output means, and configured to be controlled by said control signal for switching on or off said output means.

According to an embodiment, said input means, for example a pad, is located on a side of said cell; said output means comprises a first output interface located on another side of said cell, for example pins located on the core side of the cell ; this first output interface is electrically coupled to said input means through said switching means; said output means comprises also a second electrically conductive output interface, for example a metallic strip, extending across said cell and also electrically coupled to said input means through said switching means.

Thus, the switching means can switch on or off both the core supply but also the supply for other input/output cells of the ring.

Said control input means may comprise an electrically conductive control interface, for example another metallic strip, extending across said cell.

Said at least one supply signal is for example a supply voltage.

Said switching means may comprise at least one MOS transistor, for example a PMOS or a NMOS transistor or a combination of both.

The supply cell may further comprise, according to another embodiment, protection means against electrostatic discharge, including at least one semiconductor junction of said at least one MOS transistor.

According to another aspect, an integrated circuit is proposed, comprising an input/output ring, an always-on domain and at least one switchable domain; said at least one switchable domain includes at least one supply cell as defined above located in said input/output ring and other cells, for example conventional standard input/output cells and conventional supply cells, located in said input/output ring; each of said other cells includes an auxiliary interface, for example a metallic strip, electrically coupled to said output means of said at least one supply cell; said auxiliary interface of each of said other cells in said input/output ring is thus able to be switched on or off by said switching means of said at least one supply cell; further, said always-on domain is configured to deliver said control signal.

According to an embodiment, the auxiliary interface of each other cell in said input/output ring is electrically conductive and extends across said other cell in said input/output ring; all the cells in said input/output ring (including for example the IO cells, conventional supply cells and said at least one switchable supply cell) of said at least one switchable domain mutually abut and said at least one second electrically conductive interface and all said auxiliary electrically conductive interfaces forming together a first continuous electrically conductive rail, for example the Vdd rail, within said ring.

According to another embodiment, each of said other cells in said input/output ring comprises an additional electrically conductive interface, for example an additional metallic strip, extending across said other cell in said input/output ring; said at least one electrically conductive control interface and all said additional electrically conductive interfaces form together a second continuous electrically conductive rail within said ring, said second rail is coupled to said always-on domain, thus permitting to carry the control signal for controlling the switching means of the switchable supply cell.

Other advantages and features of the invention will appear on examining the detailed description of embodiments, these being in no way limiting, and of the appended drawings in which:
- figures 1 and 2 illustrate diagrammatically an embodiment of a switchable supply cell according to the invention;
- figures 3-5 illustrate diagrammatically embodiments of several kinds of other cells adapted to be located in an input/output ring;
- figure 6 illustrates diagrammatically an embodiment of an integrated circuit according to the invention;
- figure 7 illustrates diagrammatically more in details a part of an input/output ring belonging to a switchable domain of an integrated circuit according to the invention; and
- figures 8 and 9 illustrate diagrammatically other embodiments of supply cells according to the invention including ESD protection means.

In mobile applications, for example, one of the main customers request is small power consumption. A mobile device is most of the time in stand-by, therefore the static (leakage) power is critical. New semiconductor technologies, with shorter transistor channel and thinner gate oxide, exhibit considerably higher leakage. Therefore, it is necessary to switch off the supply for the part of the system that is in stand-by. With Systems on-Chip (SoC), it is not possible to switch off the full device since some of the parts of the system are always active. Therefore, only some parts of the SoC have to be switched off.

Using external devices, a switch is not acceptable due to increased bill of material; therefore, the switches have to be on-chip.

In conventional solutions, the switches are placed as a ring around the switched domain, and the switched domain is an island in the always-on domain (AOD).

And, the IO cells (Input/Output cells) as well as conventional supply cells are located within a ring surrounding the integrated circuit and do not belong to the switchable domain.

Consequently, the signals from the switchable domain to the IO cells have to be clamped to avoid propagation of undefined state towards other components in the system.

And, if switched supply and always-on (AOD) supply are different in value, level shifters must be introduced between the domain and the IO (input/output) ring.

Further, the power mesh is quite complex, since between the IO ring, the power rings and the switchable domain power mesh, an AOD power mesh must be present.

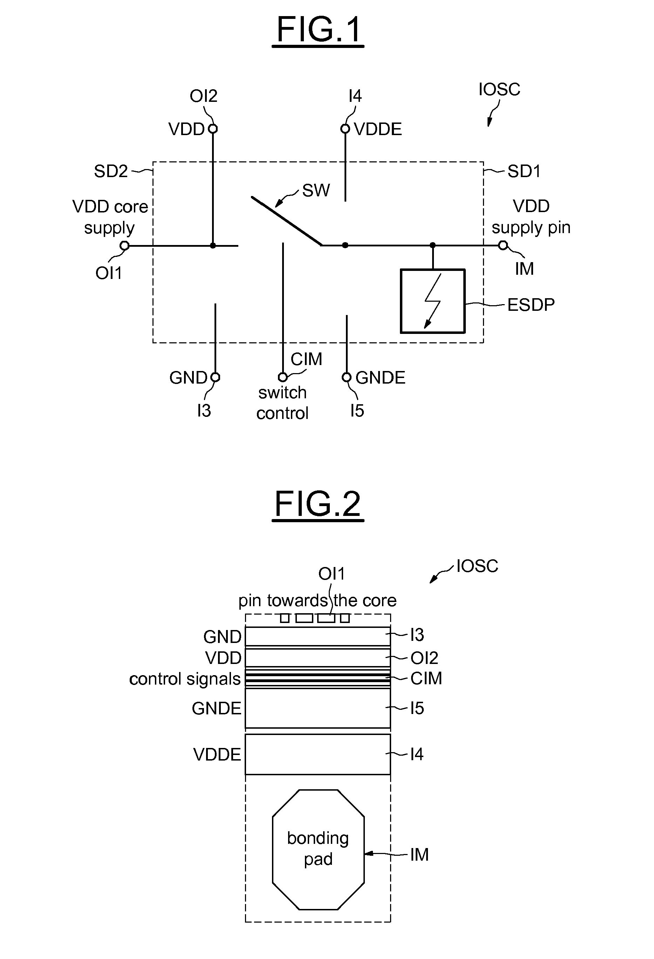

According to an aspect of the invention, it is thus proposed, as illustrated diagrammatically in figure 1 and in figure 2, a new supply cell IOSC for core power supply containing the power switch. Such a new supply cell is also named a switchable supply cell. And, as it will be explained more in details thereafter, the power switch is also switching on and off the supply of the core side of other input/output cells of the IO ring.

Further, preferably, the junctions of the power switch can be used as ESD protection as it will be explained more in details thereafter.

It is assumed here that the switchable supply is the supply voltage Vdd, and that the ground Gnd is common (not switchable). This is the common approach, simpler to implement as in the modern semiconductor technologies the ground is usually the common p-type substrate. One can, however, switch the ground supply instead, or both the power and the ground supply. The principle of switching does not change.

Turning now more particularly to figure 1, the switchable supply cell IOSC comprises input means IM located on one side SD1 of the cell and configured to receive at least one input supply signal, here the Vdd supply voltage.

The cell IOSC further comprises a first output interface OI1 located on the core side SD2 of the cell in order to deliver to the core of the switchable domain the Vdd core supply.

The cell IOSC further comprises a second electrically conductive output interface OI2 which, as illustrated in figure 2, extends across the cell. More precisely, in this example, this second electrically conductive output interface OI2 is a metallization located at a metallization level of the integrated cell, the rank of this level being without importance.

This metallization OI2 permits to deliver the Vdd supply to the other IO cells of the IO ring, as it will be indicated thereafter.

The output interfaces OI1 and OI2 are both electrically coupled to the input means IM through switching means SW. These switching means are controlled by a control signal received at a control input means CIM.

As it will be indicated more in details thereafter, the switching means may be for example a MOS transistor receiving the control signal on its gate.

As it will be explained more in details thereafter, two adjacent cells mutually abut in the IO ring, whatever the kind of cell (IO cell or switchable supply cell or conventional supply cell such as VDDE supply cell). And, each cell in said IO ring, different from a switchable supply cell IOSC, is also provided for example with a metallic strip abutting with the metallization OI2, forming thus a Vdd core rail.

And, as illustrated in figures 1 and 2, the power switch SW is placed between the pad IM, for example a bonding pad, and the Vdd core rail. This Vdd core rail passes through other cells placed in the IO ring. In this way, if the switch is turned off, the Vdd supply of all the IO cells from that domain is off. This simplifies creation of the power supply mesh (no need to route AOD supply in the core region close to IO pads). Besides, the clamps between the IO cells and the core are not needed, since both are switched on and off together.

In an IO cell, there are two positive supplies, and typically also two ground supplies. Usually, the supply voltage values for VDD and VDDE are different; but even if this is not the case, the supplies are split in order to avoid transferring of the noise from the big output buffers (in VDDE domain) into the small-signal core circuitry (VDD domain).

Thus, the cell IOSC further comprises a VDDE interface 14, a ground interface 13 and a GNDE interface 15. In this cell, those interfaces are also metallization as illustrated in figure 2. Again, when two adjacent cells of the IO ring mutually abut, all those interfaces form respectively conductive rails, for example a VDDE rail, a GND rail or a GNDE rail.

The IOSC cells are also provided with one or more other metallization adapted to carry eventual control signal. Among these metallization, one is the control input means CIM and is dedicated for carrying the control signal used for controlling the switching means SW.

Again, as it will detailed thereafter, by abutting the IO cells, another conductive rail is created for carrying the control signal from a power control unit in the always-on domain to the switching means.

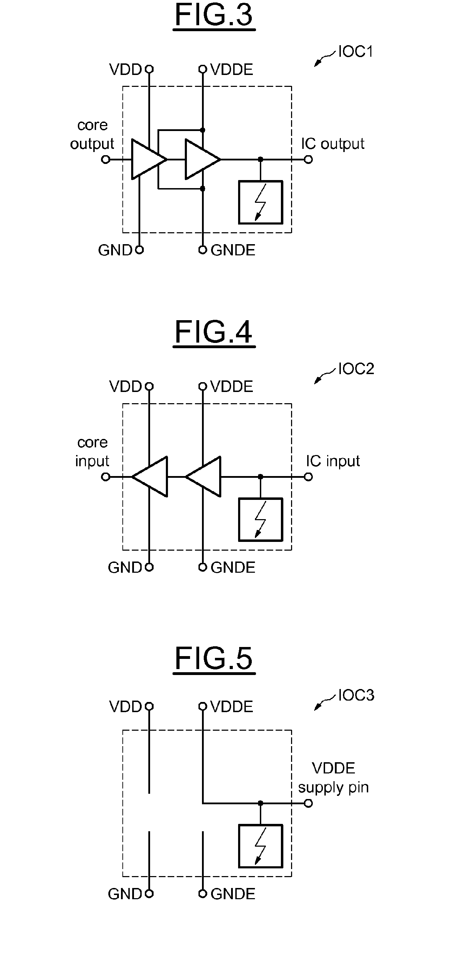

As it will be detailed thereafter, the IO ring belonging to the switchable domain may include one or several supply cells IOSC and other cells in said IO ring, for example conventional well known input/output or VDDE supply cells as for example those illustrated in figures 3-5.

More precisely, figure 3 illustrates diagrammatically an example of a conventional output cell, whereas figure 4 illustrates diagrammatically an example of a conventional input cell IOC2, and figure 5 illustrates diagrammatically an example of a conventional VDDE supply cell IOC3.

The IO cell has additional pull-up and/or pull-down and/or repeater circuitry (not shown in Figures 3 and 4) that is used to define the state of the cell outputs if only one of the supplies (VDD or VDDE) is present. This allows for arbitrary sequence of turning on and off the power supplies without any undefined states or unwanted spikes of the output signals of the cell.

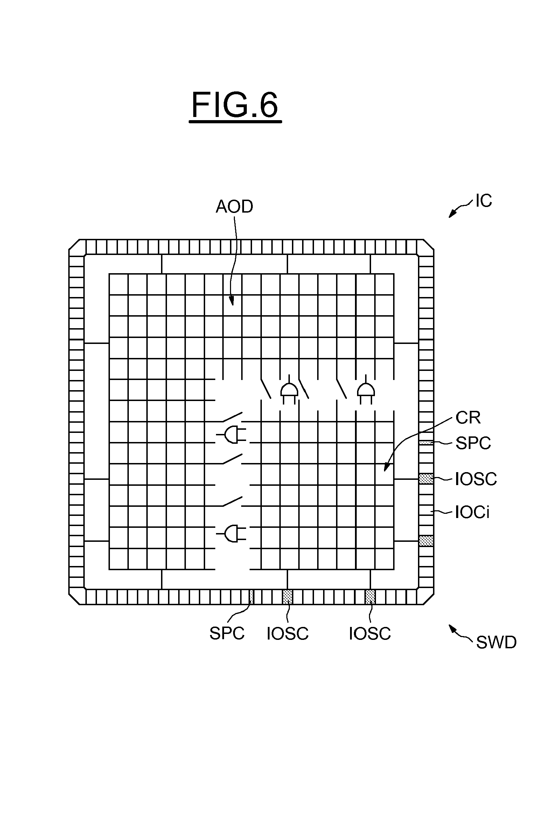

Turning now to figure 6, an example of an integrated circuit according to the invention is depicted. The integrated circuit IC comprises an always-on domain AOD and one switchable domain SWD. An input/output ring IOR surrounds the domain AOD and the core CR of the switchable domain SWD. The ring IOR contains cells including for example switchable supply cells, IO cells, and conventional supply cells.

The switchable power domain now extends also to the switchable cells IOSC. In this example, several (four) cells IOSC are provided within the ring IOR.

Further to the cells IOSC, other IO cells IOCi are provided.

Between the cells in said IO ring that belong to the switchable domain, and those that are always-on, splitter cells SPC have to be inserted, that break the core supply (Vdd) ring. Such splitter cells are usually part of a standard IO library.

Thus, according to the present embodiment of the invention, the switchable domain includes now the core CR as well as all the core side of all the cells in said IO ring, including the switchable cells IOSC and the IO cells, between the splitter cells SPC.

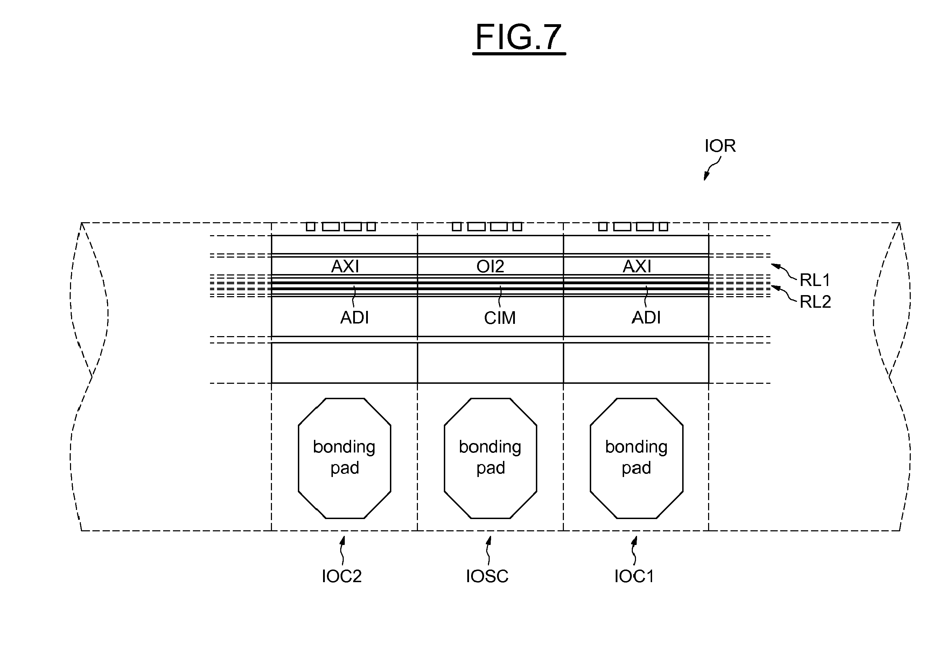

As explained above, all the cells of the ring IOR mutually abut. For example, as illustrated in figure 7, a supply cell IOSC is located between two conventional IO cells IOC1 and IOC2. Each cell IOCi comprises an auxiliary interface AXI which is electrically conductive, and which extends across the cell. Practically, as explained above, this auxiliary interface AXI is a metallization (metallic strip) which comes into contact with the interface OI2 of the cell IOSC, in order to form a first electrically conductive rail RL1, which is in the present example, the VDD rail.

By analogy, each cell IOCi comprises an additional interface ADI, which is for example one of the metallic strips extending across the cell for carrying out control signals. Again, by abutting the cells, the interface CIM and the additional interfaces ADI form together a second electrically conductive rail RL2. This rail RL2 is electrically coupled to the domain AOD and permits to carry the control signal for controlling the switching means SW of the cells IOSC.

Because the switching means SW are implemented between the pad IM of the cell IOSC, on one side, and both the VDD rail and the VDD pin towards the core CR on the other side, when the switch SW is turned off, the VDD rail RL1 is not supplied. In other words, the VDD supply is also switched of for all IO cells.

As illustrated in figure 6, the clamps and level shifters are not any more needed between the core and the IO cells in the same domain. The level shifters are not needed as the cells are in the same domain. The clamps are not needed as the standard IO cells normally have defined output even if the core voltage is not supplied, to enable user to be free with the sequence of powering the IC supplies on or off.

The clamps (gates CL) are only necessary between the core of the switchable domain and the domain AOD.

The control signal for controlling the switching means SW is an AOD (Always-on) signal, therefore its buffers must be always supplied. With embodiments of the invention, this signal can be routed through the IO ring, using a narrow metal line (one of the narrow metal rails depicted in Figure 7). Its buffers can be supplied by VDDE supply, which is always present. This simplifies the concept of power switching, since there is no need to route special AOD control signals to remotely placed switches.

Standard supply cells always contain an ESD protection. ESD protection is providing the current path toward another power rail (e.g. Gnde supply rail) in the case of ESD pulse. The ESD pulse is recognized by its amplitude, or by its fast rising edge, depending on the type of ESD protection. In a normal circuit operation, the ESD protection has to be off (not conducting the current). ESD protection takes considerable area, as it has to be designed for a large ESD current (peak value of ∼3.8A, but for a very short time).

The power switch SW may be also a big transistor, for example a MOS transistor, as the goal is to minimize the voltage drop when the switch is turned on.

As shown in Figures 1 and 2, the power switch SW is connecting the pad with the core supply, where ESD protection means ESDP is connecting the pad to ground rail. Therefore, it is not possible to use the same device for both purposes. However, some of the junctions of power switch SW can be used for the ESD protection. In this way, considerable area saving is possible.

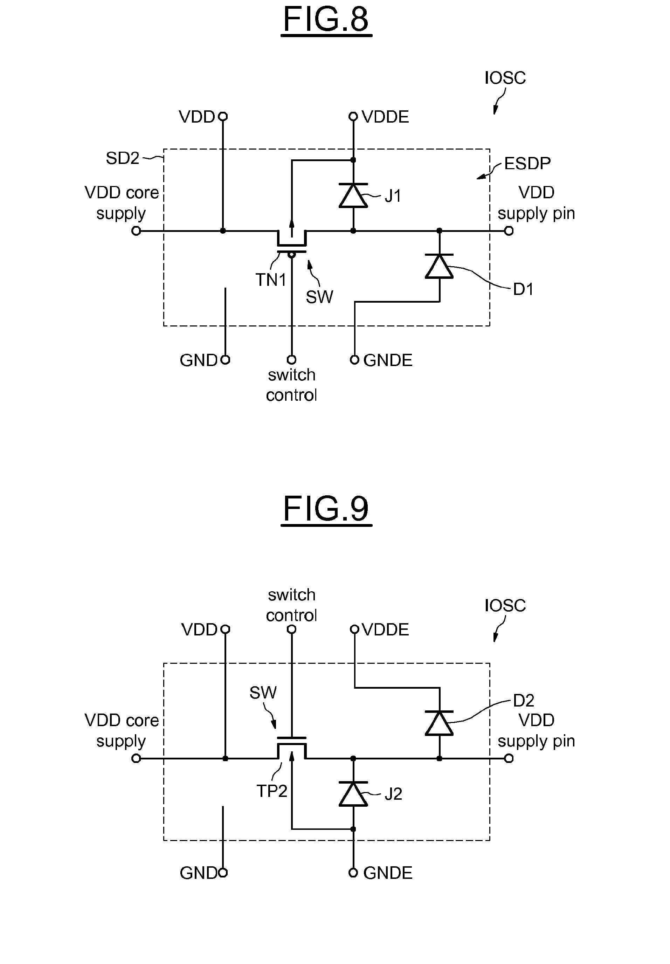

There are many different ESD protections. The choice of an ESD protection depends on the technology used and the ESD protection concept that is chosen. Figure 8 gives an example of ESD protection means ESDP when a PMOS transistor TN1 is used as power switch SW.

In this configuration, the N well of the PMOS switch TN1 is connected to Vdde supply rail. For positive ESD pulses w.r.t. Gnde, the parasitic source/bulk diode J1 of the PMOS switch provides the protection path towards Vdde, which is completed by a protection from Vdde to Gnde rail within the next Vdde supply cell. For the negative ESD pulse, however, a separate protection diode D1 has to be added. Since the diode in forward D1 bias has very big current capability, this additional diode D1 does not have to be large, therefore area saving is achieved, as compared to the usual ESD protection.

Figure 9 gives an example of the switchable supply cell with a NMOS transistor TP2 as power switch SW. In that case, the parasitic source-substrate diode (junction) J2 of the NMOS is used as the ESD protection for negative pulses. For positive pulses, an additional protection diode D2 is added.

Benefits of embodiment of this invention include simplification of power mesh, reduced number of isolation clamps and level-shifters in the implementation low power concept, and saving of the die area.

The invention can be used in mobile and other applications where reduction of the static (standby) power is important.

## Claims

1. Supply cell, comprising input means (IM) configured to receive at least one input supply signal (Vdd), output means (OI1, OI2) configured to output at least one output supply signal (Vdd), control input means (CIM) configured to receive a control signal and switching means (SW) coupled to said control input means and between said input means and said output means and configured to be controlled by said control signal for switching on or off said output means (OI1, OI2).

2. Supply cell according to claim 1, wherein said input means (IM) is located on a side of said cell, said output means comprises a first output interface (OI1) located on another side of said cell and electrically coupled to said input means through said switching means, and a second electrically conductive output interface (OI2) extending across said cell and electrically coupled to said input means through said switching means.

3. Supply cell according to any one of the preceding claims, wherein said control input means (CIM) comprises an electrically conductive control interface extending across said cell.

4. Supply cell according to any one of the preceding claims, wherein said at least one supply signal is a supply voltage (Vdd).

5. Supply cell according to any one of the preceding claims, wherein said switching means (SW) comprises at least one MOS transistor (TN1, TP2).

6. Supply cell according to claim 5, further comprising protection means (ESDP) against electrostatic discharge including at least one semiconductor junction (J1, J2) of said at least one transistor.

7. Integrated circuit, comprising an input/output ring (IOR), an always-on domain (AOD) and at least one switchable domain (SWD), said at least one switchable domain (SWD) including at least one supply cell (IOSC) according to any one of claims 1 to 6 located in said input/output ring (IOR) and other cells (IOCi) located in said input/output ring (IOR), each of said other cells in said input/output ring (IOR) including an auxiliary interface (AXI) electrically coupled to said output means of said at least one supply cell, said auxiliary interface (AXI) of each of said other cells in said input/output ring (IOR) being thus able to switched on or off by said switching means of said at least one supply cell, said always-on domain being configured to deliver said control signal.

8. Integrated circuit according to claim 7, wherein said at least one supply cell is a supply cell according to any one of claims 1 to 6 taken into combination with claim 2, and the auxiliary interface (AXI) of each other cell in said input/output ring (IOR) is electrically conductive and extends across said other cell in said input/output ring (IOR), wherein all the cells in said input/output ring (IOR) of said at least one switchable domain mutually abut, said at least one second electrically conductive interface (OI2) and all said auxiliary electrically conductive interface (AXI) forming together a first continuous electrically conductive rail (RL1) within said ring.

9. Integrated circuit according to claim 8, wherein said at least one supply cell is a supply cell according to any one of claims 1 to 6 taken into combination with claims 2 and 3, and each of said other cells in said input/output ring (IOR) comprises an additional electrically conductive interface (ADI) extending across said other cell in said input/output ring (IOR), said at least one electrically conductive control interface (CIM) and all said additional electrically conductive interface (ADI) forming together a second continuous electrically conductive rail (RL2) within said ring, said second rail being coupled to said always-on domain (AOD).
